# EUROPÄISCHE PATENTSCHRIFT

(11) **EP 0 568 973 B1**
(45) Veröffentlichungstag und Bekanntmachung des Hinweises auf die Patenterteilung: **14.08.1996**
(21) Anmeldenummer: 93107207.8
(22) Anmeldetag: 04.05.1993
(51) Int. Cl.: G01F 23/26, G01F 23/24

(54) **Niveauschalter**
Level switch
Interrupteur de niveau

(30) Priorität: 06.05.1992 SI 9200073
(43) Veröffentlichungstag der Anmeldung: 10.11.1993
(73) Patentinhaber: Eferl, Franc, SI-62351 Kamnica, Slovenia (SI); Zatler, Andrej, SI-62000 Maribor, Slovenia (SI)
(72) Erfinder: Eferl, Franc, SI-62351 Kamnica, Slovenia (SI); Zatler, Andrej, SI-62000 Maribor, Slovenia (SI)
(74) Vertreter: Lehn, Werner, Dipl.-Ing.

(56) Entgegenhaltungen:
- EP-A- 0 155 179
- EP-A- 0 288 215
- EP-A- 0 399 824
- EP-A- 0 441 381
- DE-A- 2 819 731
- DE-A- 4 217 305
- US-A- 3 956 760
- US-A- 4 214 479
- PATENT ABSTRACTS OF JAPAN vol. 8, no. 10 (P-248) 18. Januar 1984 & JP-A-58 172 520 (RICOH K.K.)

## Beschreibung

Die Erfindung betrifft einen Niveauschalter, mit dem wahrgenommen wird, daß die Oberfläche eines in einem Behälter enthaltenen Materiales das Niveau der dem Niveauschalter zugehörenden Sonde erreicht hat.

Derartige Niveauschalter werden z. B. in Silos, Sammelbehältern oder in Sammelbecken verwendet, die offen oder geschlossen, unter Luftdruck, veränderlichem oder stetigem Druck sein können. Darin enthaltene Materialien können sehr verschieden sein: flüssige, körnige oder pulverige Materialien verschiedener Dichte, Zähigkeit und Anhaftigkeit, rein oder vermischt mit festen Teilchen verschiedener Größen, mit Luftbläschen, mit einem Schaum auf der Oberfläche, homogen oder inhomogen, mit stetigen oder veränderlichen elektrischen Eigenschaften. Der Anwendungsbereich eines Niveauschalters nach dem Stand der Technik ist beschränkt und in der Regel muß der Niveauschalter auf das Material im Behälter abgeglichen werden.

Das Niveauwahrnehmen beruht auf verschiedenen Grundlagen. Man kennt mechanische, elektromechanische, hydrostatische Niveauschalter, Ultraschall-Niveauschalter, kapazitive, konduktive Niveauschalter, Mikrowellen-Niveauschalter, optische und auf der Radiometrie beruhende Niveauschalter.

Mechanische oder elektromechanische Niveauschalter sind nur für Flüssigkeiten geeignet. Wegen des Schwimmers und des Übertragungsgestänges sind sie jedoch gegen Beläge, feste Teilchen in der Flüssigkeit, Turbulenzen und Schäume an der Oberfläche empfindlich.

Kapazitive Niveauschalter sind universaler. Die Kapazität des Meßkondensators der Sonde ändert sich mit der Verschiebung des Niveaus eines im Behälter enthaltenen Materials wegen des von 1 abweichenden Wertes der Dielektrizitätskonstante des Materials.

Es ist eine kapazitive Sonde mit der Schaltung (FTC 968, beschrieben in dem Handbuch für Ingenieure; Sensoren, Meßaufnehmer, Neue Verfahren und Produkte für die Praxis, 2. Ausgabe, S. 521 bis 529, Expert Verlag, Ehningen bei Boblingen (1988)) zum Wahrnehmen des Füllstandes eines Behälters mit einem feinkörnigen Schüttgut (Korngröße bis zu 10 mm) bekannt, dessen Dielektrizitätskonstante den Wert 1,6 übersteigt. Die Sonde ist derweise entworfen, daß der störende Einfluß des an der Sonde haftenden Materialbelags selbsttätig behoben wird. Die Sonde ist aus einem hohlen und an einem Ende geschlossenen Kunststoffzylinder hergestellt, in dessen Inneren an der Basis und auch teilweise am Mantel eine Meßelektrode gefertigt ist. An der Innenwand des Zylindermantels der Sonde sind ferner noch eine Schirmelektrode und eine an Masse angeschlossene Abschlußringelektrode angeordnet. Die Schaltung mit einem Multivibrator mit einer konstanten Frequenz um 0.5 MHz stellt auf der Schirmelektrode ein Potential her, das sich mit einer Phasenverzögerung gegenüber dem Potential an der Meßelektrode ändert. Damit erreicht man, daß die Schirmelektrode die zwischen der Meßelektrode und der Abschlußringelektrode verlaufenden Feldlinien hinausschiebt. Die Feldlinien ragen darum aus dem Materialbelag an der Sonde. Der beschriebene Niveauschalter ist für ein trockenes, nicht aber für ein elektrisch leitendes feuchtes Schüttgut geeignet.

Es ist ferner auch ein kapazitiver Niveauschalter (Typ 23 und 25 der Firma VEGA, BRD) bekannt, der auch für elektrisch leitende und stark anhaftende Materialien geeignet ist. Eine vollkommen isolierte Stabsonde umfaßt eine Schutzschirmelektrode, die den Einfluß der Schicht des anhaftenden Materiales kompensiert. Die Schutzschirmelektrode leitet den unerwünschten, durch diese Schicht von der Sondenspitze zum Befestigungsstück fließenden elektrischen Strom ab.

Alle bekannte kapazitive Niveauschalter müssen auf das in dem Behälter enthaltenes Material abgeglichen werden und ihre Anzeigen sind nicht mehr zutreffend, sobald sich die Materialparameter ändern. Ebenso ist kein Niveauschalter bekannt, der ohne einen vorherigen Abgleich den Wechsel von einem elektrisch leitenden auf ein elektrisch nicht leitendes Material, von einem anhaftenden auf ein nicht anhaftendes Material u. ä. bewältigen könnte. Während also durch bekannte Niveauschalter die Aufgabe, die Senkung eines der Sonde des Niveauschalters nicht anhaftenden Materials mit einer elektrischen Leitfähigkeit unter 0,1 mS/cm wahrzunehmen, noch lösbar ist, ist das für ein anhaftendes Material mit keinem bekannten Niveauschalter, weder mit einem kapazitiven noch mit einem konduktiven, durchführbar. In solchem Extremfall verwendet man ein Ultraschall- oder ein auf der Radiometrie beruhendes Füllstandmeßgerät, das jedoch eine teure und anspruchsvolle, aber auch entwurfsmäßig oder sonst nicht immer durchführbare Lösung ist.

Bekannte konduktive Niveauschalter sind für Materialien mit der elektrischen Leitfähigkeit über 3 µS/cm geeignet und müssen auf jeweiliges in dem Gefaß vorhandenes Material abgeglichen werden. Es wird eine Sonde mit voneinander entfernten und von dem in dem Behälter vorhandenen Material umgebenen Elektroden verwendet, von denen eine an einen Oszillator mit einer konstanten Frequenz von 3 kHz und 4 kHz angeschlossen ist. Der Oszillator speist eine Brückenschaltung, in deren einem Brückenarm die Sonde des Niveauschalters und in dem anderen ein Potentiometer zum Abgleichen an das in dem Behälter enthaltene Material geschaltet sind. Das Signal von der Brückenschaltung wird in einen Vergleicher und danach über ein die Störsignale unterdrückendes Filter in einen Ausgangsverstärker geleitet. Der elektrische Widerstand des zwischen den Sondenelektroden sich befindenden Materiales kann aber als ein weiter an einen Vergleicher vermittelter Spannungsabfall an einem konstanten in der Schaltung enthaltenen Widerstand wiedergegeben werden. In dem Vergleicher wird der Arbeitspunkt für die Umschaltung eingestellt.

Es ist ein Niveauschalter (VEGATOR 261 A der Firma VEGA, BRD), bekannt, der als einziger unter den Niveauschaltern dieser Art beim Wechsel des in den Behälter enthaltenen Materials keinen Abgleich braucht. Die Sonde ist mit drei voneinander getrennten und mit einem Oszillator konstanter Frequenz 4 Khz verbundenen Ringelektroden unterschiedlicher Oberflächen versehen. Die Ausgewogenheit der Widerstände des Materials unter den Elektroden ermöglicht, daß der Niveauschalter in Materialien mit einer niedrigen elektrischen Leitfähigkeit zwischen 1 µS/cm und 15 µS/cm funktionieren kann. Dieser Niveauschalter ist jedoch nicht für Materialien sehr niedriger Leitfähigkeit, zum Beispiel destilliertes Wasser, geeignet.

Kein Niveauschalter sondern ein kapazitiver Näherungsschalter ist in der nachveröffentlichten EP 0 518 836 A1 beschrieben. Ein positiv und negativ rückgekoppelter Operationsverstärker und eine kapazitive Sonde bilden einen astabilen Multivibrator, dessen Frequenz sich mit dem Abstand eines Gegenstandes in der Umgebung der Sonde ändert. Die Sonde ist mit einer ersten Elektrode und mit einer Gegenelektrode versehen, die an einen Roboterarm als Masse angeschlossen ist. Ein weiterer kapazitiver Näherungsschalter ist in EP 0 441 381 A1 beschrieben. Zwischen zwei übereinander liegenden Elektroden ist eine Schirmelektrode angeordnet, die durch einen Impedanzwandler mit der Verstärkung gleich 1 an den invertierenden Eingang des Operationsverstärkers angeschlossen ist. Die Spannung an der Schirmelektrode ist somit gleichphasig mit der Spannung an der ersten Elektrode, wie auch beim Niveauschalter FTC 968. Der beschriebene kapazitive Näherungsschalter ist nur in einer reinen Umgebung anwendbar, und kann nicht als Niveauschalter verwendet werden. Schon durch einen dünnen Belag, zum Beispiel durch einen Staubbelag oder durch einen Kondensbelag an der ersten Elektrode oder an der Schirmelektrode wird die Oszillationsfrequenz des astabilen Multivibrators geändert. Durch die Anordnung der Schirmelektrode, an der die Spannung gleichphasig mit der Spannung an der ersten Elektrode ist, wurde die Empfindlichkeit des kapazitiven Schalters zwar gesteigert, doch wurde durch eine solche Phasenbeziehung der genannten Spannungen bei gleicher Anordnung oder Elektroden nicht die größtmögliche Empfindlichkeit des beschriebenen kapazitiven Schalters erreicht.

Der Erfindung liegt die Aufgabe zugrunde, einen Niveauschalter zu schaffen, mit dem eine Absenkung der Oberfläche von Materialien mit verschiedensten Eigenschaften, d.h. eines flüssigen, körnigen oder pulverigen sowie eines elektrisch leitenden oder nicht leitenden und auch eines stark anhaftenden und nicht anhaftenden Materials, unter das Niveau der dem Niveauschalter zugeordneten Sonde ungeachtet eines an der Sonde anhaftenden Materials wahrgenommen wird, ohne daß bei dem Wechsel von einem in dem Behälter enthaltenen Material zu einem anderen Material jedesmal eine Abgleichung des Niveauschalters erforderlich ist.

Die genannte Aufgabe wird erfindungsgemäß durch einen Niveauschalter mit dem im Patentanspruch 1 angegebenen Merkmalen gelöst. Weiterbildungen der Erfindung ergeben sich aus den Unteransprüchen.

Bei dem erfindungsgemäßen Niveauschalter wird die Detektierung anhand der Höhe der Frequenz des in der Schaltung erzeugten Oszillatorsignals durchgeführt. Ein Vorteil des durch die Erfindung vorgeschlagenen Niveauschalters liegt darin, daß der Niveauschalter nicht jedesmal eigens abgeglichen zu werden braucht, wenn das Material in dem Behälter gewechselt wird, auch wenn es sich um Materialien sehr verschiedener Eigenschaften handeln sollte. Sowohl elektrisch leitende wie auch elektrisch nicht leitende, anhaftende sowie nicht anhaftende, flüssige, poröse, körnige, teigartige oder breiartige Materialien. Ein weiterer Vorteil des erfindungsgemäßen Niveauschalters besteht auch darin, daß seine elektrische Schaltung einfach und aus wenigen Elementen zusammengebaut ist.

Bei der Erfindung ist die Schirmelektrode mit dem Ausgang des Operationsverstärkers und die Plattenelektrode mit dem invertierenden Eingang des Operationsverstärkers verbunden. Die Verbindung erfolgt vorteilhaft dergestalt, daß die Platte direkt und die Schirmelektrode über einen Kondensator an den Operationsverstärker angeschlossen sind. Die Gegenelektrode ist mit Masse verbunden, indem sie beispielsweise direkt an Masse angeschlossen oder an Netzerde direkt und an Masse über eine RC-Parallelschaltung angeschlossen ist.

Die Ausführungsbeispiele der Erfindung sind in der Zeichnung dargestellt und werden im folgenden näher beschrieben.

Es zeigen:
- Fig. 1 und 2: einen konduktiven bzw. kapazitiven Niveau schalter, in denen ein Operationsverstärker und eine Sonde einen Oszillator bilden, so daß seine Frequenz von den physikalischen Verhältnissen um die Sonde abhängig ist,
- Fig. 3: einen kapazitiven Niveauschalter gemäß einem ersten Ausführungsbeispiel des erfindungsgemäßen Niveauschalters,
- Fig. 4: einen kombinierten Niveauschalter gemäß einem zweiten Ausführungsbeispiel des erfindungsgemäßen Niveauschalters.

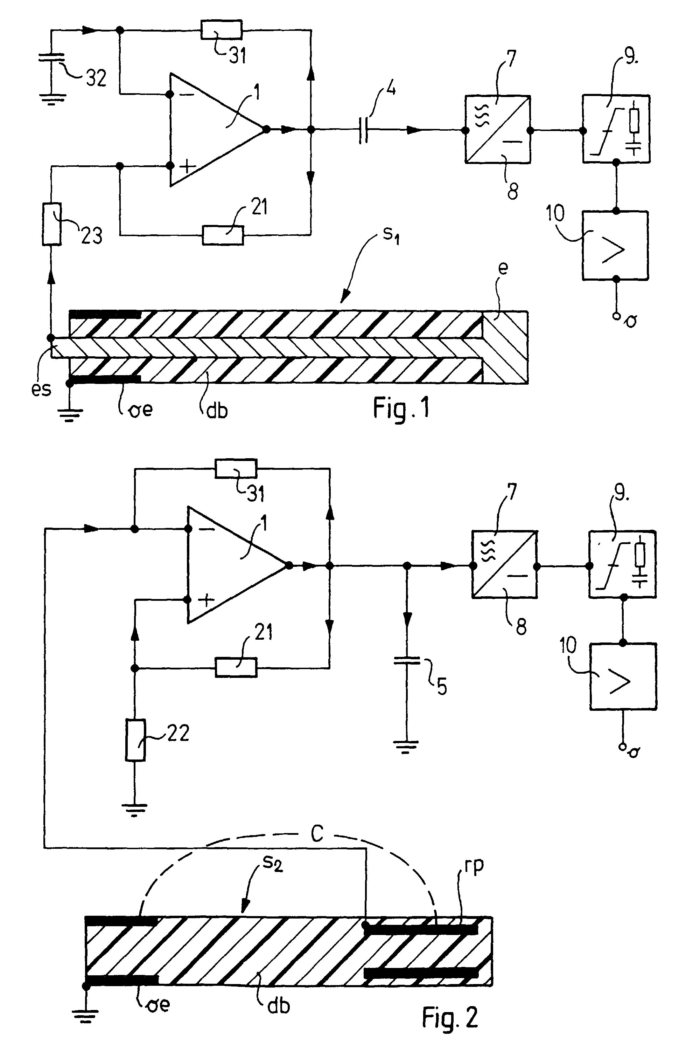

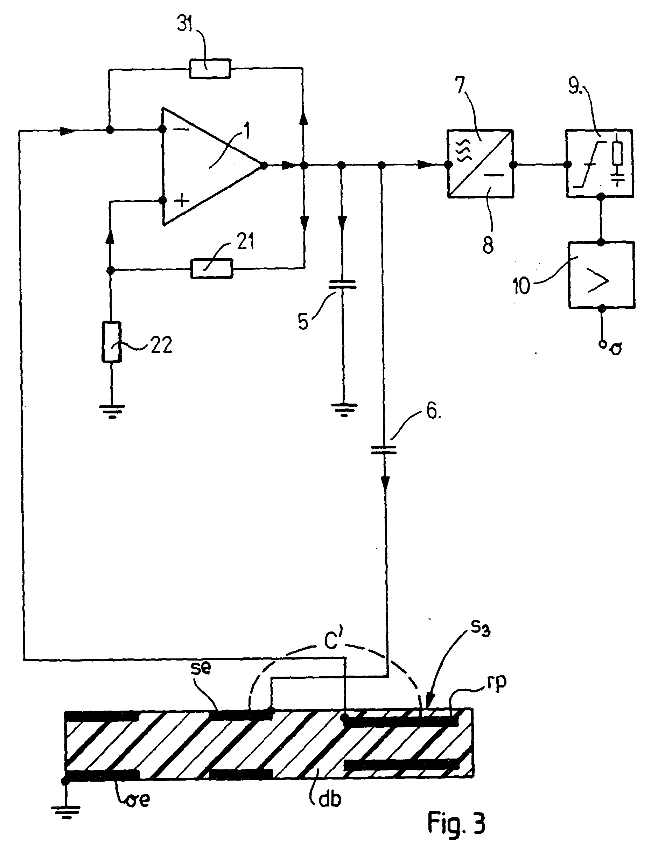

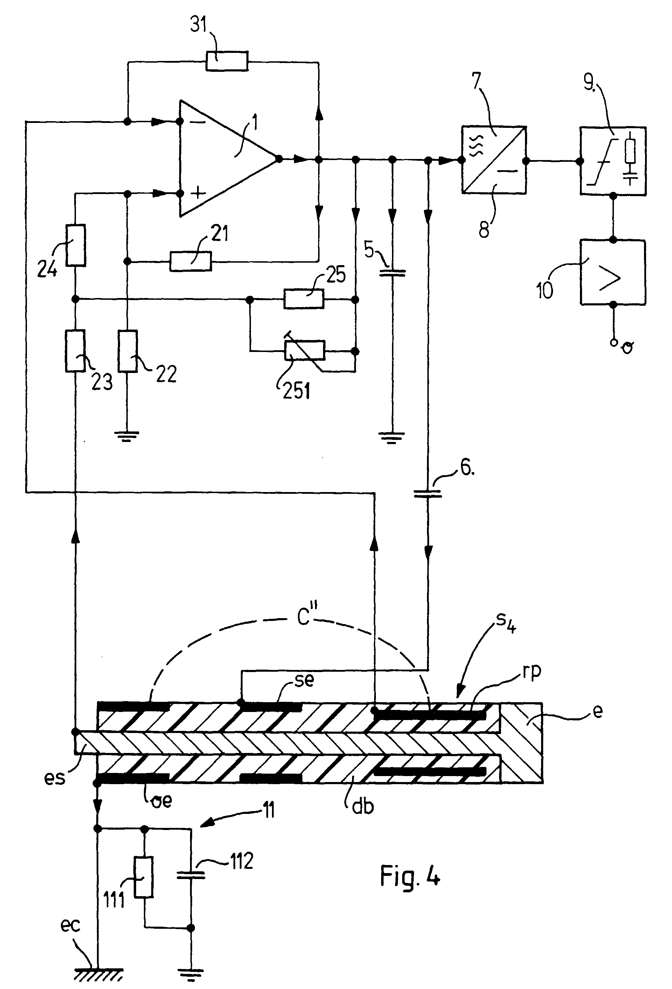

Bei beiden Ausführungsbeispielen der Erfindung (Fig. 3 und 4) und auch bei den beiden zur Erläuterung dienenden Ausführungen (Fig. 1 und 2) ist der Niveauschalter mit einer Sonde sⱼ (j = 1 bis 4) und mit einer dazugehörenden Schaltung dargestellt, an deren Ausgang ein Relais und/oder eine Alarmanlage angeschlossen sind (nicht dargestellt). Dabei ist die Sonde sⱼ jedesmal aus einem zylindrischen dielektrischen Körper db gefertigt und mit einer ringartigen Gegenelektrode oe versehen, die in der Umfangsrichtung ein Ende des dielektrischen Körpers db umgibt und an Masse beziehungsweise in der praktischen Anwendung an den ein Material enthaltenden Behälter angeschlossen ist. Bei allen Niveauschaltern ist ein Operationsverstärker 1 durch Widerstände 21, 31 positiv beziehungsweise negativ rückgekoppelt und bildet zusammen mit der Sonde sⱼ einen Oszillator. Die Frequenz des Oszillators hängt von den physikalischen Verhältnissen um die Sonde sj ab, doch die Ausgangspannung des Oszillators ist stetig und wird vorteilhaft als Sättigungsspannung des verwendeten Operationsverstärkers 1 gewählt. Der Ausgang des Operationsverstärkers 1, dessen Speisung auf eine an sich bekannte Weise ausgeführt ist, ist direkt oder indirekt an den Eingang einer Formschaltung angeschlossen, deren Ausgang auch den Ausgang o des Niveauschalters darstellt. Die Formschaltung besteht aus in Serie geschalteten einem frequenztiefen Bandfilter 7, einem Gleichrichter 8, einem wesentlich aus einer Zener-Diode und einem Kondensator bestehenden Amplitudenbegrenzer 9, von dem übriggebliebene Spitzen unterdrückt werden, und einem Verstärker 10.

Vor der Erläuterung der Ausführungsbeispiele des erfindungsgemäßen Niveauschalters wird zunächst ein konduktiver Niveauschalter beschrieben (Fig. 1). Der zylindrische dielektrische Körper db der Sonde s₁ ist an seinem freien Ende durch eine Elektrode e abgeschlossen. Ein Schaft es der Elektrode e durchdringt den dielektrischen Körper db axial und ragt an dem anderen Ende des dielektrischen Körpers db daraus. Der Elektrodenschaft es und damit die Elektrode e ist über einen Widerstand 23 an den nichtinvertierenden Eingang des Operationsverstärkers 1 angeschlossen, dessen invertierender Eingang über einen Kondensator 32 an Schaltungsmasse angeschlossen ist. Der Ausgang des Operationsverstärkers 1 ist über einen als Hochfrequenzfilter funktionierenden Kondensator 4 an den Eingang des frequenztiefen Bandfilters 7 angeschlossen.

Die elektrische Spannung an dem nichtinvertierenden Eingang des Operationsverstärkers 1 hängt von dem Widerstand des sich zwischen den Elektroden e, oe befindenden Materials ab, denn der Operationsverstärker 1 ist über den Widerstand 23, über die Elektrode e, das Material zwischen den Elektroden e und oe und über die Elektrode oe mit Masse verbunden. Diese Spannung beeinflußt jedoch die Geschwindigkeit der Ladung beziehungsweise der Entladung des Kondensators 32 über einen Widerstand 31. Auf diese Weise wird die Oszillatorfrequenz durch die elektrische Leitfähigkeit und Verteilung des Materials um die Sonde s₁ bestimmt.

Die Parameter der passiven Elemente im Oszillator, also auch die Oberfläche der Elektroden e, oe und ihr gegenseitiger Abstand werden aufgrund der Voraussetzung einer Gleichheit der Wechselstrom-Signalamplituden an den Elektroden e, oe in beiden Halbperioden bestimmt, d.h. es soll der Einfluß galvanischer Erscheinungen unterdrückt werden. Diese Beziehungen sind der Fachmann bekannt und werden durch komplexe Erscheinungen bei dem Übergang des elektrischen Stromes zwischen zwei Elektroden erklärt, wo eine frequenzabhängige Phasenverschiebung zwischen dem Strom und der Spannung entsteht. Nun wird die Oszillatorfrequenz auf den Wert um 3 kHz für die Materialien mit einer hohen elektrischen Leitfähigkeit um 0,1 S/cm und auf den Wert um 300 Hz für die Materialien mit einer niedrigen elektrischen Leitfähigkeit um 10 µS/cm eingestellt.

Es ist daher günstig den Widerstand 31 und den Kondensator 32 so zu bestimmen, daß an dem Ausgang des Operationsverstärkers immer die Sättigungsspannung erreicht wird. Das wurde z.B. für Materialien mit der elektrischen Leitfähigkeit in den Grenzen zwischen 10 µS/cm und 0,1 S/cm erreicht. Durch Ändern der Passivelemente des Oszillators kann die untere Grenze des Leitfähigkeitsintervalls der Materialien bis zur elektrischen Leitfähigkeit des destillierten Wassers gesenkt werden, d.h. bis zu 2 µS/cm. In dem Fall wird aber auch die obere Grenze des Intervalls auf 0,01 S/cm gesenkt.

Wenn jedoch die Oberfläche des anhaftenden Materials unter das Niveau der Sonde s₁ des konduktiven Niveauschalters absinkt, bleibt auf der Sonde s₁ ein dünner Materialbelag. Der Ohmwert und die Induktivität dieser Schicht für den Wechselstrom zwischen den Elektroden e und oe steigen und die Oszillatorfrequenz sinkt. Der Kondensator 4 läßt nun nur wenig elektrischen Strom durch, was stark auf die Spannung an dem Ausgang o einwirkt. Bei gering anhaftenden Materialien wird der Kondensator 4 mit gleicher Kapazität für elektrisch gut oder schlecht leitende Materialien verwendet. Doch muß man bei elektrisch gut leitenden Materialien mit einer Leitfähigkeit zwischen 1 mS/cm und 100 mS/cm die Kapazität des Kondensators 4 soweit herabsetzen, daß das Signal stark unterdrückt sein wird, wenn das Material so stark anhaftet, daß an der Sonde s₁ ein starker Belag bleibt, wenn sich die Oberfläche des Materials unter das Niveau der Sonde s₁ zurückzieht.

Der konduktive Niveauschalter arbeitet also mit einer konstanten Spannungsamplitude an dem Ausgang des Oszillators, doch ändert sich die Frequenz des Oszillators, wenn die Oberfläche des in dem Behälter enthaltenden Materials unter das Niveau der Sonde s₁ absinkt. Das Verhalten des Niveauschalters wird daher schlicht durch die Kapazität des Kondensators 4 eingestellt. Mit derselben elektronischen Schaltung deckt man Materialien mit der elektrischen Leitfähigkeit zwischen 10 µS/cm und 0,1 S/cm, d.h. alle in der Industrie und sonst technisch interessante Materialien.

Zur weiteren Vorbereitung der Schilderung der erfindungsgemäßen Ausführungs beispiele wird im folgenden noch ein kapazitiver Niveauschalter in der Grundausführung erläutert (Fig. 2). In dem zylindrischen dielektrischen Körper db der Sonde s₂ ist an seinem freien Ende koaxial eine Ringplatte rp eingebaut, die an den invertierenden Eingang des Operationsverstärkers 1 angeschlossen ist. Die Ringplatte rp ist also durch die dielektrische Schicht des dielektrischen Körpers db von dem in dem Behälter enthaltenen und die Sonde s₂ umgebenden Material getrennt.

Bei diesem Niveauschalter wie auch beim ersten und zweiten Ausführungsbeispiel des Niveauschalters nach der Erfindung ist der an Masse angeschlossene Widerstand 22 mit seiner zweiten Klemme an den nichtinvertierenden Eingang des Operationsverstärkers 1 angeschlossen, dessen Ausgang über einen Kondensator 5 an Masse angeschlossen ist.

Die Ausgangsspannung des Operationsverstärkers 1 bewirkt die Aufladung und die Entladung eines zwischen der Ringplatte rp und der Gegenelektrode oe aufgebauten und über den Widerstand 31 in der negativen Rückkopplung geschalteten virtuellen Kondensators C. Die Entladungs- beziehungsweise Aufladungsgeschwindigkeit des Kondensators C hängt natürlich von der Kapazität des Kondensators C ab, d. h. von der Dielektrizitätskonstante, der elektrischen Leitfähigkeit und der Verteilung des Materials, das den dielektrischen Körper db der Sonde s₂ in dem Raum umgibt, in dem die Feldlinien zwischen der Ringplatte rp und der Gegenelektrode oe verlaufen, sowie von der Spannung an dem invertierenden Eingang des Operationsverstärkers 1. Diese Spannung kann jedoch in Bezug auf die Spannung an dem Ausgang des Operationsverstärkers 1 durch ein geeignetes Verhältnis der Widerstände 21, 22 eingestellt werden. Bei den gewählten Parametern der passiven Elemente in dem kapazitiven Niveauschalter ist demnach die Oszillatorfrequenz nur von Eigenschaften und von der Verteilung des Materials um die Sonde s₂ abhängig. Bei der Ausführung der eigentlichen Sonde s₂ wird jedoch die Oszillatorferquenz durch die Oberflächen und die Durchmesser der ringartigen Gegenelektrode oe und der Ringplatte rp, durch ihren Längsabstand sowie durch die Dielektrizitätskonstante des zylindrischen dielektrischen Körpers db bestimmt.

Die Forderung nach der Amplitudengleichheit des Wechselstromsignals in beiden Halbperioden wird bei dem kapazitiven Niveauschalter nicht so streng wie bei dem konduktiven Niveauschalter gestellt. Die Parameter der passiven Oszillatorelemente werden so bestimmt, daß die Amplitude der Ausgangsspannung des Operationsverstärkers 1 den Sättigungspunkt erreicht.

Der Niveauschalter in der kapazitiven Grundausführung funktioniert im Falle eines elektrisch gut leitenden in dem Behälter enthaltenen Materiales folgendermaßen. Wegen der guten elektrischen Leitfähigkeit bewegt sich die Gegenelektrode oe scheinbar in Richtung zu der Ringplatte rp, wodurch die Kapazität des Kondensators C steigt, und zwar desto mehr je höher die elektrische Leitfähigkeit des Materials ist. Sobald also die Sonde s₂ mit dem elektrisch leitenden Material umgeben wird, sinkt die Oszillatorfrequenz ab, und zwar mehr bei einer hohen elektrischen Leitfähigkeit, z. B. 0,1 S/cm, und weniger bei einer niedrigeren elektrischen Leitfähigkeit, z. B. 2 µS/cm. Wenn aber die Materialoberfläche unter das Niveau der Sonde s₂ absinkt, bleibt das Material an der Sonde s₂ als ein dünner Belag haften. Dadurch fällt die Kapazität des Kondensators C ab und die Oszillatorfrequenz steigt an. Der Kondensator 5 leitet jedoch das Hochfrequenzsignal an dem Ausgang des Operationsverstärkers 1 an Masse ab. Der Kondensator 5 wirkt demnach als ein Niederfrequenzfilter. Im Falle eines elektrisch schwach leitenden und stark anhaftenden Materials wählt man eine höhere Kapazität des Kondensators 5.

Der kapazitive Niveauschalter der beschriebenen Ausführung ist jedoch auch für elektrisch nicht leitende Materialien sehr gut geeignet. Da die Dielektrizitätskonstante des Materials jedenfalls den Wert 1 übersteigt, spiegelt sich nun die Materialanwesenheit, im Vergleich zur Situation, wenn die Materialoberfläche unter das Niveau der Sonde s₂ absinkt, bloß an der Erhöhung der Kapazität des Kondensators C und damit an der Absenkung der Oszillatorfrequenz

Der kapazitive Niveauschalter ist besonders für nicht anhaftende Materialien mit der elektrischen Leitfähigkeit zwischen 0,2 µS/cm und 1 mS/cm gut geeignet.

Der Niveauschalter gemäß dem ersten Ausführungsbeispiel der Erfindung ist als eine weitere Ausführungsform des kapazitiven Niveauschalters ausgeführt (Fig. 3). Die Sonde s₃ und die dazugehörige Schaltung sind gegenüber denen bei dem Niveauschalter nach Fig. 2 folgenderweise ergänzt. Auf dem Umfang des zylindrischen dielektrischen Körpers db der Sonde s₃ ist zwischen der Gegenelektrode oe und der Ringplatte rp eine Schirmelektrode se ausgeführt, die über den Kondensator 6 an den Ausgang des Operationsverstärkers 1 angeschlossen ist.

Bei der Beschreibung der Funktionsweise des ersten Ausführungsbeispieles des Niveauschalters gehen wir von der Funktionsweise des Niveauschalters nach Fig. 2 aus. Betrachten wir einen schwierigen Fall eines elektrisch gut leitenden anhaftenden Materiales. Wenn die Oberfläche des Materiales unter das Niveau der Sonde s₃ absinkt, wird durch den zwischen der Gegenelektrode oe und der Schirmelektrode se an dem dielektrischen Körper db anhaftenden Belag elektrischer Kontakt von dem Ausgang des Operationsverstärkers 1 über den als frequenztiefes Bandfilter wirkenden Kondensator 6, über die Schirmelektrode se und über die Gegenelektrode oe zur Masse hergestellt und dadurch wird die Spannungsamplitude an dem Ausgang des Operationsverstärkers 1 kleiner. Dazu verschiebt sich noch die Schirmelektrode se scheinbar gegen die Ringplatte rp und dazwischen bildet sich ein virtueller Kondensator C', dessen Kapazität niedrig ist, da sein Wirkungsraum auf den Materialbelag um die Sonde s₃ begrenzt ist. Die Oszillatorfrequenz ist darum hoch und eine der Platten seines Kondensators C', nämlich das ist die Schirmelektrode se, ist darum über den Kondensator 6 an den Ausgang des Operationsverstärkers 1 gebracht. Außerdem ist die Ringplatte rp des Kondensators C' über den Widerstand 31 an den Ausgang des Operationsverstärkers 1 angeschlossen. Kurzum, die Kapazität des Kondensators C' ist gering. Darum ist die Oszillatorfrequenz sehr hoch und das Hochfrequenzsignal wird durch den Kondensator 5 an Schaltungsmasse abgeleitet. Das zum Ausgang o des Niveauschalters angelangte Signal ist im Unterschied zum Signal in der Situation, wenn die Materialoberfläche das Niveau der Sonde s₃ übersteigt, sehr schwach. In jener Situation ist die Oszillatorfrequenz niedriger, denn die Kapazität des Kondensators C' ist größer wegen seines weiter reichenden Wirkungsraumes in dem Material.

Durch die Schirmelektrode se steigt die Leistungsfähigkeit des Niveauschalters nach Fig. 3 im Vergleich zum Niveauschalter in Fig. 2, weil er auch für elektrisch gut leitende Materialien, die aber zugleich auch stark an dem dielektrischen Körper db der Sonde s₃ haften bleiben, geeignet ist. Der kapazitive Niveauschalter in dem ersten Ausführungsbeispiel nach der Erfindung übertrifft alle bis jetzt bekannte Niveauschalter in Hinsicht auf die Mannigfaltigkeit der Materialien in seinem Anwendungsbereich.

Der Niveauschalter nach der Erfindung ist in dem zweiten Ausführungsbeispiel als ein kombinierter konduktiv-kapazitiver Niveauschalter ausgeführt (Fig. 4). Die Sonde s₄ umfaßt eine Elektrode e, die Gegenelektrode oe, eine Schirmelektrode se und eine Ringplatte rp, die alle an dem zylindrischen dielektrischen Körper db montiert sind. Dabei umgibt die ringartige Gegenelektrode oe ein Ende des dielektrischen Körpers db, und nahe am anderen Ende des mit der Elektrode e abgeschlossenen dielektrischen Körpers db ist darin die Ringplatte rp koaxial eingebaut. Am Umfang des dielektrischen Körpers db ist zwischen der Gegenelektrode oe und der Ringplatte rp die Schirmelektrode se angebracht. Der metallene Schaft es der Elektrode e dringt axial durch den dielektrischen Körper db hindurch und ragt an dem anderen Ende des dielektrischen Körpers db hinaus.

In der Schaltung des zweiten Ausführungsbeispieles des erfindungsgemäßen Niveauschalters ist der invertierende Eingang eines Operationsverstärkers 1, bei dem die positive und die negative Rückkopplung durch einen Widerstand 21 beziehungsweise durch einen Widerstand 31 realisiert sind, an die Ringplatte rp der Sonde s₄ angeschlossen und der nichtinvertierende Eingang des Operationsverstärkers 1 ist über seriengeschaltete Widerstände 23,24 an das freie Ende des Schaftes es der Elektrode e angeschlossen. Die Schirmelektrode se ist über den Kondensator 6 an den Ausgang des Operationsverstärkers 1 angeschlossen. Der Ausgang des Operationsverstärkers 1 ist über einen Widerstand 25 und einen dazu parallel geschaltenen regelbaren Widerstand 251 an die gemeinsame Klemme der Widerstände 23,24 angeschlossen. Der Masse angeschlossene Widerstand 22 ist mit seiner zweiten Klemme an den nichtinvertierenden Eingang des Operationsverstärkers 1 angeschlossen, dessen Ausgang über den Kondensator 5 mit Masse verbunden ist. Der Ausgang des Operationsverstärkers 1 ist über hintereinander verbundene ein frequenztiefes Bandfilter 7, einen Gleichrichter 8, einen Amplitudenbegrenzer 9 und einen Verstärker 10 mit dem Ausgang o des Niveauschalters verbunden. Die ringartige Gegenelektrode oe ist bei der Anwendung in elektrisch sehr gut leitenden Materialien mit der Leitfähigkeit zwischen 0,1S/cm und 1S/cm und sogar höher, um eine Verformung der Spannungsamplitude an der Sonde s₄ zu vermeiden, an die Erde ec des elektrischen Netzes und über ein aus einem Widerstand 111 und einen parallel dazu geschaltenen Kondensator 112 zusammengesetzten Filter 11 noch an Masse der Schaltung angeschlossen.

Mit dem regulierbaren Widerstand 251 stellt man Niveauschalter mit unterschiedlich großen Sonden s₄ auf das gleiche Verhalten ein.

Die Schirmelektrode se wirkt sowohl auf den konduktiven als auch auf den kapazitiven Teil des kombinierten Niveauschalters, wobei beide Wirkungen auf eine komplexe Weise verflochten sind. In dem konduktiven Teil stellt sich die von der elektrischen Leitfähigkeit des Materials abhängige positive Rückkopplung von dem Ausgang des Operationsverstärkers 1 über den Kondensator 6 und über das Material zwischen der Schirmelektrode se und der Elektrode e zurück an den nichtinvertierenden Eingang des Operationsverstärkers 1 ein. Die Schirmelektrode se wirkt über das die Sonde s₄ umgebende Material auch als ein Spannungsteiler zwischen der Gegenelektrode oe und der Elektrode e und übt dadurch eine Wirkung auf die Spannung an dem nichtinvertierenden Eingang des Operationverstärkers 1 aus. In dem kapazitiven Teil wirkt sie jedoch auf die Bildung eines virtuellen Kondensators C'' ein, dessen Platten die Ringplatte rp und die Gegenelektrode oe sind. Indem die Schirmelektrode se mit dem Ausgang des Operationsverstärkers 1 verbunden ist, wird die Kapazität des Kondensators C" herabgestellt. Dadurch wird eine zu niedrige Oszillatorfrequenz, besonders bei elektrisch sehr gut leitenden Materialien, vermieden. Die Kapazität des Kondensators C" wird jedoch auch von der Gegenelektrode oe auf die gleiche Weise beeinflußt. Die Gegenelektrode oe ist einerseits mit dem nichtinvertierenden Eingang des Operationsverstärkers 1 verbunden, andererseits hat sie aber einen über das elektrisch gut leitende Material hergestellten Kontakt zu der Schirmelektrode se.

Auf diese Überlegungen stützen wir uns bei der Beschreibung der Funktionsweise des kombinierten Niveauschalters nach der Erfindung. Setzen wir zunächst voraus, daß die Sonde s₄ in ein Material, das an der Sonde s₄ gut haftet und elektrisch gut leitend ist, z. B. in einen Salzteig, eingetaucht wird. Der Oszillator in der Schaltung des Niveauschalters reagiert auf ein solches Material folgendermaßen. Das elektrisch gut leitende Material rückt die Ringplatte rp und die Gegenelektrode oe, die den virtuellen Kondensator C" bilden, scheinbar näher zusammen. Der Kondensator C" ist an den invertierenden Eingang des Operationsverstärkers 1 angeschlossen. Sein nichtinvertierender Eingang ist über das Material zwischen der Elektrode e und der Gegenelektrode oe mit Masse verbunden. Zugleich ist die Elektrode e mit dem anderen Eingang des Operationsverstärkers 1 als die Ringplatte rp verbunden und vermindert dadurch die Kapazität des Kondensators C". Die Schirmelektrode se wirkt einerseits als eine zusätzliche Rückkopplung, andererseits aber wirkt sie in Abhängigkeit von der elektrischen Leitfähigkeit als Spannungsteiler und beeinflußt die Spannung an dem nichtinvertierenden Eingang. Die Oszillatorfrequenz ist den genannten regulierenden Einflüssen unterworfen, die von der Anwesenheit des Materiales herrühren. Wenn aber die Materialoberfläche unter das Niveau der Sonde s₄ absinkt, reagiert der erfindungsgemäße Niveauschalter unabhängig davon, ob das elektrisch gut leitende Material zum Teil haftend an der Sonde s₄ zurückgeblieben ist. Der Belag aus dem elektrisch gut leitenden Material verhilft auf die oben beschriebene Weise zum Erscheinen des virtuellen Kondensators C", dessen Kapazität jedoch stark durch die Elektrode e und die Gegenelektrode oe herabgesetzt wird. Die Schirmelektrode se liegt nämlich räumlich gesehen zwischen der Ringplatte und der Gegenelektrode oe, während die Elektrode e und die Schirmelektrode se mit dem nicht-invertierenden Eingang beziehungsweise mit dem Ausgang des rückgekoppelten Operationsverstärkers 1 verbunden sind. Vor allem ist die Dicke des Materialbelages an der Sonde s₄ sehr begrenzt, die Entstehung des Kondensators C" ist aber an Schichten beschränkt, deren Dicke einen Kleinstwert überschreitet. Wenn der Kondensator C" verschwindet, hört der Oszillator zu funktionieren auf, was von der dem Operationsverstärker 1 nachgeschalteten Formschaltung wahrgenommen wird, und das zeigt sich am Signal an dem Ausgang o des kombinierten Niveauschalters nach der Erfindung. Wenn aber doch die Dicke des Materialbelags groß genug ist, daß sich der Kondensator C" bilden kann, ist seine Kapazität niedrig und demnach die Oszillatorfrequenz hoch, schätzungsweise über 20 kHz. Dieses Signal wird über den Kondensator 6, die Schirmelektrode se und den Materialbelag zwischen der Schirmelektrode se und der Gegenelektrode oe an Masse abgeleitet.

Es folgt daraus, daß für eine gute Funktion des kombinierten Niveauschalters nach der Erfindung in ganz beliebigen Verhältnissen eine sorgfältige Berechnung der Schaltungselemente und der Sonde s₄ nötig ist. So muß man sorgfältig die Abstände der Elektroden oe, se, e und der Ringplatte rp voneinander und den Durchmesser der Ringplatte rp bestimmen, damit die Schirmelektrode se nicht die Entstehung des Kondensators C" verhindern würde. Es ist auch die Qualität des den dielektrischen Körper db bildenden Dielektrikums wichtig. Der Durchmesser des Schaftes es hat Auswirkung auf seine Parasitkapazität zur Ringplatte rp. Wir haben festgestellt, daß die Oszillatorfrequenz, wenn die Materialoberfläche über dem Niveau der Sonde s₄ liegt, zwischen 1 kHz und 20 kHz liegt, wobei die elektrische Leitfähigkeit des Materiales zwischen 10 pS/cm und 1 S/cm lag; der kombinierte Niveauschalter funktioniert daher zuverlässig für elektrisch nicht leitende wie auch für elektrisch sehr gut leitende Materialien.

Der kombinierte Niveauschalter gemäß dem zweiten Ausführungsbeispiel des Niveauschalters nach der Erfindung ist überall anwendbar. Der Oszillator in der Schaltung des Niveauschalters oszilliert, wenn die Sonde s₄ in ein Material mit der elektrischen Leitfähigkeit von einem vernachläßigbaren Wert bis zu 1 S/cm und unabhängig von der Anhaftigkeit des Materials und davon, ob es flüssig, pulverig oder breiartig ist, eingetaucht ist. Daher funktioniert der kombinierte Niveauschalter sehr gut auch überall, wo herkömmliche kapazitive Niveauschalter versagen, wie z. B. bei einem feucht und dadurch auch elektrisch leitend gewordenen pulverigen Material.

Der erfindungsgemäße Niveauschalter funktioniert also in beiden Ausführungsbeispielen mit einer konstanten Spannungsamplitude an dem Ausgang des Oszillators, es ist aber die Oszillatorfrequenz, die sich ändert, wenn die Oberfläche des in dem Behälter enthaltenen Materiales unter das Niveau der Sonde sⱼ (j = 3 oder 4) sinkt. Das Verhalten des Niveauschalters wird bei der Herstellung einfach durch die Kapazität des als Frequenzfilter funktionierenden und den Ausgang des Operationsverstärkers 1 mit dem Eingang des frequenztiefen Bandfilters 7 verbindenden Kondensators 4 oder 5 eingestellt. Mit demselben erfindungsgemäßen Niveauschalter, d. h. elektronischer Schaltung und Sonde, beherrscht man alle in der Industrie oder anderswo technisch interessante Materialien.

## Patentansprüche

1. Niveauschalter, in dem ein Operationsverstärker (1) und eine Sonde (s₃; s₄) einen Oszillator bilden, so daß seine Frequenz von den physikalischen Verhältnissen um die Sonde (s₃;s₄) abhängig ist, wobei der operationsverstärker positiv und negativ durch einen ersten beziehungsweise einen zweiten Widerstand (21, 31) rückgekoppelt ist und an den nichtinvertierenden Eingang des Operationsverstärkers (1) ein dritter Widerstand (22) angeschlossen ist, dessen andere Klemme an Masse angeschlossen ist, und die Sonde (s₃;s₄) mit einer als eine Elektrode ausgestalteten Platte (rp) und mit einer mit Masse verbundenen Gegenelektrode (oe) versehen ist,
wobei die Platte (rp) in einen dielektrischen Körper (db) der Sonde (s₃; s₄) nahe an seinem ersten Ende eingebaut ist und die Gegenelektrode (oe) an der Oberfläche des anderen Endes des dielektrischen Körpers (db) angeordnet ist,
wobei eine Schirmelektrode (se) an der Oberfläche des dielektrischen Körpers (db) der Sonde (s₃; s₄) zwischen der Platte (rp) und der Gegenelektrode (oe) angeordnet ist, und
wobei die Schirmelektrode (se) mit dem Ausgang des Operationsverstärkers (1) und die Platte (rp) mit dem invertierenden Eingang des Operationsverstärkers (1) verbunden sind.

2. Niveauschalter nach Anspruch 1,
dadurch **gekennzeichnet**, daß
an der Oberfläche des dielektrischen Körpers (db) der Sonde (s₄) an dem anderen Ende als die Gegenelektrode (oe) eine Elektrode (e) angeordnet ist, und
die Elektrode (e) über hintereinander geschaltete vierten Widerstand (23) und fünften Widerstand (24) an den nichtinvertierenden Eingang des Operationsverstärkers (1) angeschlossen ist, dessen Ausgang über zueinander parallel geschaltete einen sechsten Widerstand (25) und einen einstellbaren Widerstand (251) an eine gemeinsame Klemme des vierten und fünften Widerstandes (23, 24) angeschlossen ist.

3. Niveauschalter nach Anspruch 2,
dadurch **gekennzeichnet**, daß
die Gegenelektrode (oe) an die Erde (ec) des elektrischen Netzes und über ein RC-Filter (11) an Masse der Schaltung angeschlossen ist.

4. Niveauschalter nach einem der Ansprüche 1 bis 3,
dadurch **gekennzeichnet**, daß
der Ausgang des Operationsverstärkers (1) über einen ersten Kondensator (5) an Masse angeschlossen ist.

5. Niveauschalter nach Anspruch 4,
dadurch **gekennzeichnet**, daß
die Schirmelektrode (se) an den Ausgang des Operationsverstärkers (1) über einen zweiten Kondensator (6) angeschlossen ist.

6. Niveauschalter nach Anspruch 5,
dadurch **gekennzeichnet**, daß
der dielektrische Körper (db) zylinderartig ausgeführt ist und die elektrisch leitende Platte (rp), die Schirmelektrode (se) und die Gegenelektrode (oe) ringartig ausgeführt sind, wobei die elektrisch leitende Platte (rp) koaxial in den dielektrischen Körper (db) eingebaut ist, der von der Schirmelektrode (se) und Gegenelektrode (oe) umgeben ist.

## Claims

1. A level switch in which an operational amplifier (1) and a sensor (s₃; s₄) constitute an oscillator so that its frequency depends on the physical conditions around the sensor (s₃; s₄), the operational amplifier being provided with a positive and a negative feedback accomplished by a first resistor (21) and a second resistor (31), respectively, and the non-inverting input of the operational amplifier (1) being connected to a resistor (22), the second terminal of which is grounded, and the sensor (s₃; s₄) being provided with an electrode-like plate (rp) and with a grounded opposite electrode (oe),
wherein the plate (rp) is incorporated in a dielectric body (db) of the sensor (s₃; s₄) near a first end of the dielectric body (db) and the opposite electrode (oe) is mounted on the surface of a second end of the dielectric body (db),
wherein a screening electrode (se) is mounted on the surface of the dielectric body (db) of the sensor (s₃; s₄) between the plate (rp) and the opposite electrode (oe), and
wherein the screening electrode (se) is connected to the output of the operational amplifier (1) and the plate (rp) is connected to the inverting input of the operational amplifier (1).

2. A level switch as recited in claim 1, characterized in that
on the surface of the dielectric body (db) of the sensor (s₄) an electrode (e) is mounted at an end different from the one where the opposite electrode (oe) is mounted, and
the electrode (e) is connected through a series connection of a fourth resistor (23) and a fifth resistor (24) to the non-inverting input of the operational amplifier (1), whose output is connected through a sixth resistor (25) shunted by an adjustable resistor (251) to the common terminal of the fourth and the fifth resistor (23, 24).

3. A level switch as recited in claim 2, characterized in that
the opposite electrode (oe) is connected to the electrical network ground (ec) and, through a RC-filter (11), to the circuit ground.

4. A level switch as recited in claim 1, 2 or 3, characterized in that
the output of the operational amplifier (1) is grounded through a first capacitor (5).

5. A level switch as recited in claim 4, characterized in that
the screening electrode (se) is connected through a second capacitor (6) to the output of the operational amplifier (1).

6. A level switch as recited in claim 5, characterized in that
the dielectric body (db) has a cylindrical shape and the electrically conductive plate (rp), the screening electrode (se) and the opposite electrode (oe) have an annular form, whereat the electrically conductive plate (rp) is coaxially incorporated in the dielectric body (db), which is surrounded by the screening electrode (se) and by the opposite electrode (oe).

## Revendications

1. Interrupteur à niveau, dans lequel un amplificateur opérationnel (1) et une sonde (s₃; s₄) forment un oscillateur, de sorte que sa fréquence est fonction des conditions physiques autour de la sonde (s₃; s₄), l'amplificateur opérationnel est contre-réactionné positivement et négativement par l'intermédiaire d'une première ou bien d'une deuxième résistance (21, 31) et une troisième résistance (22) étant raccordée à l'entrée non inverseuse de l'amplificateur opérationnel (1), résistance dont l'autre borne est raccordée à la masse, et la sonde (s₃;s₄) étant munie d'une plaque (rp) conçue comme une électrode et d'une contre-électrode (oe) reliée à une masse,
la plaque (rp) étant montée dans un corps (db) diélectrique de la sonde (s₃; s₄) à proximité de sa première extrémité et la contre-électrode (oe) est disposée à la surface de l'autre extrémité du corps diélectrique (db),
une grille de protection (se) étant disposée à la surface du corps diélectrique (db) de la sonde (s₃; s₄) entre la plaque (rp) et la contre-électrode (oe), et
la grille de protection (se) étant reliée à la sortie de l'amplificateur opérationnel (1) et la plaque (rp) à l'entrée inverseuse de l'amplificateur opérationnel (1).

2. Interrupteur à niveau selon la revendication 1, caractérisé en ce qu'une électrode (e) est disposée à la surface du corps diélectrique (db) de la sonde (s₄) sur l'autre extrémité par rapport à la contre-électrode (oe), et l'électrode (e) est raccordée par une quatrième résistance (23) et une cinquième résistance (24) montées en série à l'entrée non inverseuse de l'amplificateur opérationnel (1), dont la sortie est raccordée, par une sixième résistance (25) et une résistance réglable (251) montées en parallèle, à une borne commune des quatrième et cinquième résistances (23, 24).

3. Interrupteur à niveau selon la revendication 2, caractérisé en ce que la contre-électrode (oe) est raccordée à la masse (ec) du réseau électrique et, par un filtre RC, à la masse du circuit.

4. Interrupteur à niveau selon l'une quelconque des revendications 1 à 3, caractérisé en ce que la sortie de l'amplificateur opérationnel (1) est raccordée à la masse par un premier condensateur (5).

5. Interrupteur à niveau selon la revendication 4, caractérisé en ce que la grille de protection (se) est raccordée à la sortie de l'amplificateur opérationnel (1) par un deuxième condensateur (6).

6. Interrupteur à niveau selon la revendication 5, caractérisé en ce que le corps diélectrique (db) est conçu comme un cylindre et la plaque électroconductrice (rp), la grille de protection (se) et la contre-électrode (oe) sont mises en forme d'anneau, la plaque électroconductrice (rp) étant montée de façon coaxiale dans le corps diélectrique (db) qui est entouré par la grille de protection (se) et la contre-électrode (oe).
